# EUROPEAN PATENT APPLICATION

(11) **EP 2 861 048 A1**
(43) Date of publication of application: **15.04.2015**
(21) Application number: 13290245.3
(22) Date of filing: 14.10.2013
(51) Int. Cl.: H05K 7/20

(54) **Housing element for an electronic device**

(71) Applicant: ALCATEL LUCENT, 92100 Boulogne-Billancourt (FR)
(72) Inventor: Neustadt, Alf, 70435 Stuttgart (DE)
(74) Representative: DREISS Patentanwälte PartG mbB

(57) **Abstract**

The invention relates to a housing element (100) for an electronic device (10, 20), wherein said housing element (100) comprises thermally conductive material, wherein said housing element (100) comprises at least one opening (101), preferably a slit (101), between adjacent area regions (102, 104) of said housing element (100) to increase a thermal resistance between said area regions (102, 104), and wherein said at least one opening (101) is at least partly filled with sealing material (108).

## Description

### Field of the invention

The invention relates to a housing element for an electronic device, wherein said housing element comprises thermally conductive material.

The invention further relates to a method of providing such housing element.

### Background

Conventional housing elements which are used for constructing housings for electric and/or electronic devices and the like are for example provided in form of a basically planar piece of thermally conductive material which enables to attach heat sources such as high power electronic devices to an inner surface of the housing element thereby enabling heat distribution/cooling of said heat source by means of heat transfer from the heat source to the housing element. Moreover, an outer surface of the housing element may further be cooled by convection cooling or forced air cooling or the like. Disadvantageously, when mounting a plurality of heat sources to a conventional housing element, the thermal conductivity of the material the housing element is made of enables an undesired transfer of heat energy within the housing element from a first heat source which is operating at a higher temperature level to a second heat source that is operating at a lower temperature level as compared to the first heat source. Thus, instead of efficiently removing all heat energy from an inside of a housing comprising such conventional housing element to an outside, also at least partly a transfer of heat energy between different heat sources attached to the same housing element takes place.

### Summary

In view of this, it is an object of the present invention to provide an improved housing element and an improved method of providing such housing element that avoid the aforementioned disadvantages of prior art. Regarding the housing element of the above-mentioned type this object is achieved by said housing element comprising at least one opening between adjacent area regions of said housing element to increase a thermal resistance between said area regions, and in that said at least one opening is at least partly filled with sealing material.

According to an embodiment, the at least one opening may preferably be provided in form of a slit or the like and/or may comprise a slit.

The provisioning of the at least one opening advantageously reduces a potential thermal energy transfer across or within the material of the housing element itself. Additionally, providing the sealing material within said at least one opening advantageously enables to maintain protection of devices (heat sources such as semiconductors or the like) within a housing comprising the housing element from environmental influences such as dust, humidity or the like. In other words, providing the at least one opening in combination with at least partly filling with sealing material said at least one opening advantageously enables to partition the housing element according to the embodiments into different thermal domains with reduced potential for heat energy transfer between said thermal domains. At the same time, such housing element may be used for hermetically sealing devices to be protected from environmental influences because the sealing material closes the gaps which result from providing the at least one opening according to the embodiments.

According to an embodiment, said thermally conductive material of said housing element comprises a thermal conductivity of about 100 W / (m * K) (Watt per meter and Kelvin) or higher, wherein said thermally conductive material comprises for example one of: magnesium, brass, aluminium, gold, copper, silver. According to an embodiment, the housing element is completely made of one single material, e.g. die cast aluminium. According to further embodiments, combinations of different materials are also possible for said housing element.

According to a further embodiment, said sealing material comprises a thermal conductivity of about 20 W / (m * K) or less, preferably of about 1 W / (m * K) or less, wherein said sealing material comprises for example at least one of: polymerized siloxanes (i.e., silicones), epoxides, stainless steel, aerogel. Thus, an efficient and reliable sealing of the one or more openings is possible while maintaining an increased thermal resistance within said gap filled with the sealing material.

According to a further embodiment said housing element comprises a basically rectangular shape, wherein said at least one opening extends substantially parallel to one edge of said rectangular shape. This yields different thermal domains according to the basic principle of the embodiments and enables an efficient use of the inner surface area of the housing element for mounting different (electronic) components.

According to a further embodiment, the sealing material does not cover a whole cross-section area of said at least one opening, whereby a further increase of the thermal resistance at the position of the sealed opening can be attained. At the same time, sealing material may be saved.

According to a further embodiment, an aggregated length of said opening or openings along a width coordinate is greater than 60 percent of a total width of said housing element, preferably greater than 85 percent of said total width of said housing element, thus further increasing the thermal resistance between the adjacent area regions surrounding the opening(s).

According to a further embodiment, a plurality of openings are provided, wherein an aggregated shape of said plurality of openings basically corresponds to a "U"-shape thus further increasing the thermal resistance between the adjacent area regions surrounding the opening(s).

According to a further embodiment, one or more opposing edge sections of said area regions comprise a recess thus even further increasing the thermal resistance between the adjacent area regions surrounding the opening(s).

According to a further embodiment, a circuit carrier for receiving at least one of said electronic devices is provided on an inner surface of said housing element, wherein said circuit carrier preferably at least partly extends over both adjacent area regions of said housing element thus enabling one or more electric contacts across the different thermal domains associated with said adjacent area regions. Thereby, additional electromechanical connector means for connecting devices arranged within a first thermal domain to devices arranged within a second thermal domain and the like may be saved.

According to a further embodiment, said circuit carrier, which may e.g. be a printed circuit board or a hybrid circuit carrier or the like, comprises at least one electrically conductive surface that is arranged to at least partly cover said at least one opening, wherein said at least one electrically conductive surface preferably establishes an electrically conductive contact between said adjacent area regions of said housing element, whereby a high degree of protection against electromagnetic interference (emi) is attained, i.e. preventing electromagnetic radiation from emanating from an inside of the housing comprising the housing element according to the embodiments to a surrounding areas.

According to a further embodiment, said housing element comprises at least one cooling unit on an outer surface, wherein preferably at least two distinct cooling units are associated with respective ones of said area regions. In this context, "distinct" cooling unit means that the two cooling units are not contacting each other. Rather, they may at best be mounted on the same housing element. When placing these distinct cooling units in different, thermally separated, area regions, of the same housing element, an efficient cooling of the respective area regions is enabled, although substantially no direct heat transfer between the cooling elements occurs.

A further solution to the object of the present invention is provided by a housing for an electronic device, wherein said housing comprises at least one housing element according to the embodiments.

A further solution to the object of the present invention is provided by a method of providing a housing element for an electronic device, wherein said method comprises: providing said housing element comprising thermally conductive material, providing at least one opening, preferably a slit, between adjacent area regions of said housing element to increase a thermal resistance between said area regions, at least partly filling said at least one opening with sealing material.

According to an embodiment, said at least one opening is provided a) during a process of die casting said housing element and/or b) after a process of die casting said housing element, e.g. by milling.

### Brief description of the figures

Further features, aspects and advantages of the present invention are given in the following detailed description with reference to the drawings in which:
- Figure 1a: schematically depicts a housing element according to an embodiment,
- Figure 1b: schematically depicts a perspective view of the housing element of figure 1a,
- Figure 1c: schematically depicts a side view of the housing element according to figure 1a,
- Figure 2: schematically depicts a side view of a housing element according to a further embodiment,
- Figure 3a, 3b, 3c: schematically depict a top view of further embodiments of the housing element with a heat flow indicated by arrows,
- Figure 4a, 4b, 4c, 4d: schematically depict cross-sectional side views of housing elements according to further embodiments,
- Figure 5a: schematically depicts a top view of an inner surface side of a housing element according to a further embodiment,
- Figure 5b: schematically depicts a top view of an outer surface side of the housing element according to figure 5a,
- Figure 6: schematically depicts a top view of a detail of the housing element according to a further embodiment,
- Figure 7: schematically depicts a simplified flow chart of a method according to an embodiment,
- Figure 8: schematically depicts a side view of a housing according to an embodiment,
- Figure 9: schematically depicts a side view of a housing according to a further embodiment, and
- Figure 10: schematically depicts a perspective view of a housing element according to a further embodiment.

### Description of the embodiments

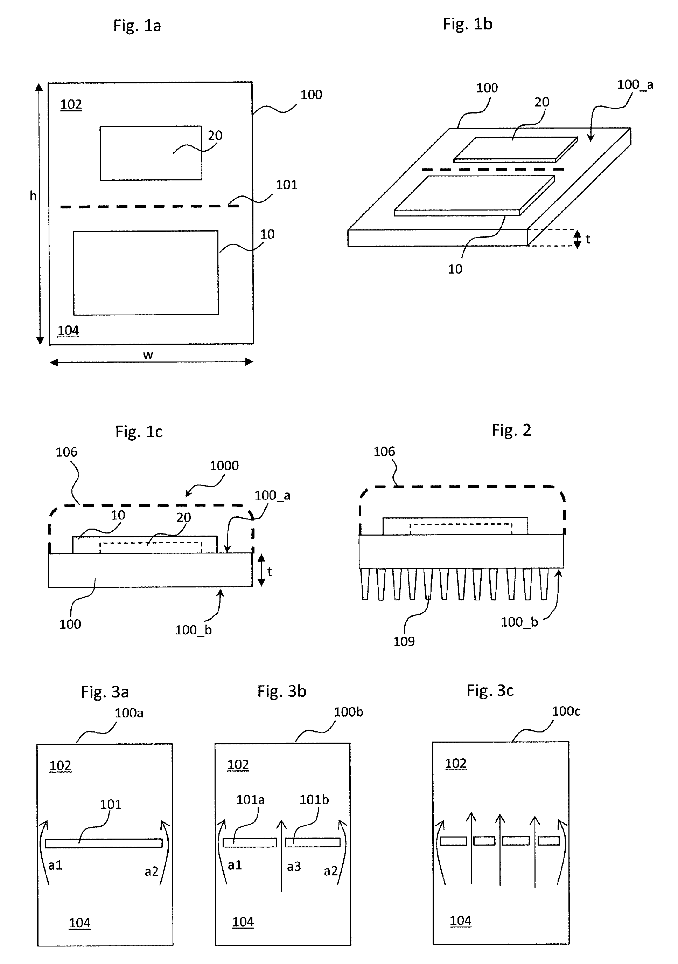

Figure 1a schematically depicts a top view of an inner surface side of a housing element 100 according to an embodiment. The housing element 100 may be used e.g. as a side wall portion of a housing for electronic devices 10, 20 which are to be protected from environmental influences such as heat, radiation, dust and the like.

Although the embodiments are not restricted thereto, the housing element 100 schematically depicted by figure 1a comprises a basically rectangular shape comprising a width w and a height h. Of course, other shapes for the housing element according to the embodiments are also possible, also non-planar (i.e., curved) shapes or the like. However, for the sake of simplicity, the further explanations mainly relate to a housing element with the basic geometry as depicted by figure 1a.

The housing element 100 comprises, or may preferably be made of, thermally conductive material such as magnesium, brass, aluminium, gold, copper, silver or the like. From an economic point of view, according to one example, aluminium, e.g. die cast aluminium, is preferable. According to a preferred embodiment, the complete housing element 100 is made of said thermally conductive material such as aluminium.

Although the electronic devices 10, 20 depicted by figure 1a do not form part of the invention, they are exemplarily depicted as being arranged on the housing element 100. For example, the electronic devices 10, 20 may comprise high power semiconductors or the like dissipating heat in a per se known fashion. The devices 10, 20 may therefore be arranged on an inner surface side of the housing element 100 in a thermally conductive manner to enable heat transfer from the devices 10, 20 to the housing element 100 and from the housing element 100 to a surrounding area such as environment the housing element 100 is located in.

According to the principle of the embodiments, said housing element 100 comprises at least one opening 101, preferably in the form of a slit or the like, between adjacent area regions 102, 104 of the housing element 100, whereby a thermal resistance between the area regions 102, 104 is increased. Thus, the housing element 100 may advantageously be partitioned into thermally separated domains wherein only a reduced degree of heat transfer between the areas 102, 104 and the components 10, 20 arranged therein is enabled, as compared to a housing element without said opening 101.

Presently, in figure 1a, the opening 101 is schematically symbolized by a dashed line. Further, according to the principle of the embodiments, said at least one opening 101 is at least partly filled with sealing material (not shown in figure 1a), which prevents dust, humidity and the like to transit from an outer surface side of the housing element 100 to an inner surface side of the housing element 100. Preferably, the sealing material has a significantly higher thermal resistance as compared to the material of the housing element 100, whereby thermal separation of the area regions 102, 104 is maintained while providing protection from environmental influences by means of the sealing.

Figure 1b schematically depicts a perspective view of the housing element 100 of figure 1a. An inner surface side 100_a faces upward in figure 1b and receives the electronic devices 10, 20. A thickness of the housing element 100 is indicated with reference sign t.

Figure 1c schematically depicts a side view of the configuration of figure 1a, figure 1b. In addition to the housing element 100, a further housing component 106 is depicted by figure 1c, which may be arranged together with the housing element 100 according to the embodiments to form a complete housing 1000. It is to be noted that the further housing component 106 is merely symbolically indicated by a dashed line in figure 1c and may e.g. be represented by a correspondingly shaped piece of aluminium or the like. Also, flanges (not shown) or other fastening means may be provided at a mechanical interface between components 100, 106 for reliably attaching the components 100, 106 to each other. The main advantages of the principle according to the embodiments is the thermal separation of the usually monolithic housing element 100 (figure 1a) into different thermal regions 102, 104, whereby heat transfer between the regions 102, 104 is reduced. At the same time, the sealing applied to the opening 101, which enables the thermal separation between the area regions 102, 104, provides reliable protection of an inner space of the housing 1000 (figure 1c) from environmental influences.

An outer surface of the housing element 100 is denoted by reference sign 100_b in figure 1c. Cooling of the devices 10, 20 comprised within the housing 1000 may be effected as follows: device 10 transfers heat energy mainly to the area region 104 (Fig. 1a) it is attached to, more precisely to the inner surface portion 100_a of said area region 104. The heat energy is further transported along the thickness coordinate t of the housing element 100 to the outer surface 100_b of the housing element, thus removing the heat energy of device 10 from an inside of the housing 1000 to its outside, e.g. the environment, wherein convection cooling and/or forced air cooling and the like may be used to control the temperature of the outer surface 100_b. In analogy to device 10, device 20 transfers heat energy mainly to the area region 102 (Fig. 1a) it is attached to, more precisely to the inner surface portion 100_a of said area region 102. The heat energy is further transported along the thickness coordinate t of the housing element 100 to the outer surface 100_b of the housing element, thus removing the heat energy of device 10 from an inside of the housing 1000 to its outside, e.g. the environment, wherein convection cooling and/or forced air cooling and the like may be used to control the temperature of the outer surface 100_b. Due to the thermal separation effected by the opening 101, hardly any heat transfer between regions 102, 104 will occur within the housing element, whereby components 10, 20 are efficiently thermally separated from each other.

Figure 2 schematically depicts a further embodiment of a housing element. In addition to the configuration of figure 1c, the housing element depicted by figure 2 comprises cooling fins 109 to improve a heat transfer from the housing element to the environment, e.g. by convection cooling and/or by forced air cooling and the like.

Figure 3a shows a top view of a further embodiment 100a of the housing element. The opening 101 basically comprises slit form and separates the area regions 102, 104 thermally from each other. A heat flow from e.g. area region 104 to area region 102 is still enabled by small material portions at the opposing axial end sections of the slit 101, cf. the arrows a1, a2. However, in contrast to a conventional housing element without any openings 101, the heat transfer from region 104 to region 102 is substantially reduced.

Figure 3b depicts a housing element 100b according to a further embodiment. The housing element 100b comprises two openings 101a, 101b each of them comprising basically slit geometry. Heat transfer is symbolized by arrows a1, a2, a3. In contrast to the embodiment according to figure 3a, the figure 3b embodiment provides an increased mechanical stability, because three connecting elements of the housing element material mechanically connect the regions 102, 104 with each other. Thus, despite the opening(s) 101, .., the housing element according to the embodiments may be handled as a monolithic, i.e. one-piece, component (this also holds true for the embodiment 100a of Fig. 3a).

Figure 3c depicts a further embodiment 100c of the housing element. This configuration comprises four slits basically extending in a horizontal direction of figure 3c.

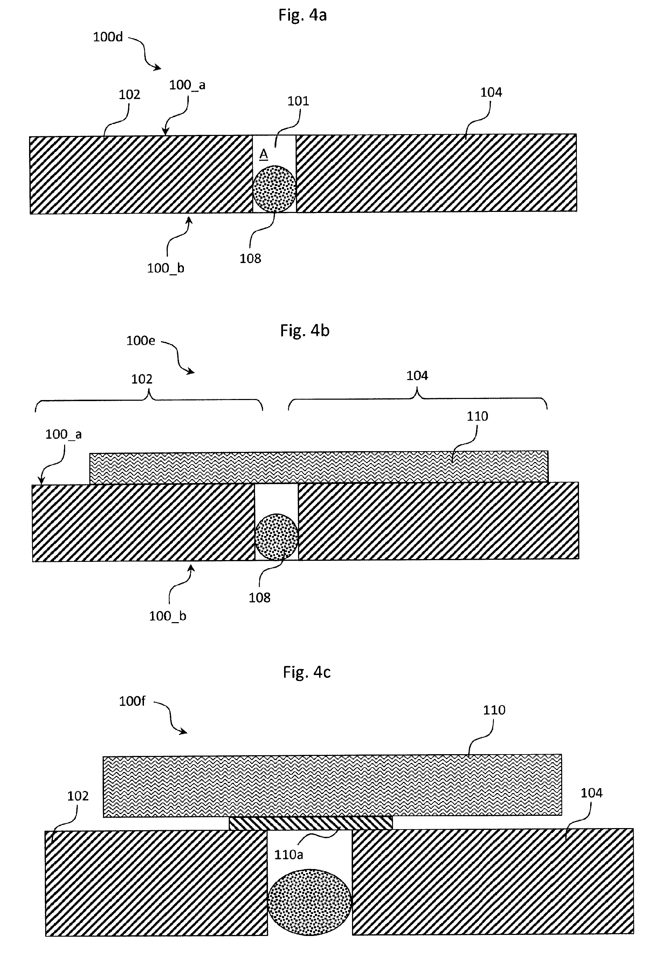

Figure 4a schematically depicts a cross-sectional side view of a housing element 100d according to a further embodiment. As can be seen from figure 4a, the opening 101 comprises a basically rectangular geometry. According to a preferred embodiment, the sealing material 108 at least partly fills the opening 101 or the opening cross section A, respectively.

However, according to a further preferred embodiment, the sealing material 108 does not cover the whole cross section area A of said at least one opening 101, whereby a further increase of the thermal resistance between the area regions 102, 104 is attained.

Figure 4b depicts a cross-sectional view of a further embodiment 100e. In addition to the figure 4a embodiment, a circuit carrier 110 is provided on the inner surface 100_a of the housing element 100e. As can be seen from figure 4b, the circuit carrier 110, which may e.g. be implemented in the form of a printed circuit port (PCB), bridges the different area regions 102, 104, which are thermally separated from each other according to the embodiments by the opening 101. Thereby, e.g. the electronic devices 10, 20 depicted by figure 1a may be arranged on a common circuit carrier 110 thus avoiding to provide electrical connecting means between a plurality of different circuit carriers associated with the respective area regions 102, 104. Rather, according to the present embodiment 100e, a single circuit carrier 110 may be provided for carrying electric devices or electronic devices 10, 20 each of which requires heat transfer to the housing element 100e, and each of which is thermally separated from each other via the opening 101. Although the PCB 110 as such again introduces a heat transfer path between regions 102, 104, its thermal conductivity is rather small as compared to the material of the housing element 100e, so that the thermal resistance between regions 102, 104 is not increased significantly by the provisioning of the PCB 110.

Figure 4c depicts a further embodiment 100f, wherein said circuit carrier 110 comprises at least one electrically conductive surface 110a which according to a further preferred embodiment bridges the gap resulting from the opening 101 according to the embodiments. This advantageously enables to establish an electrically conductive contact between the area regions 102, 104 of the housing element 100f thereby reducing potential EMI problems of this configuration. Advantageously, the conductive surface 110a may e.g. be implemented in the form of a copper layer of the printed circuit port 110, which, although comprising electrical conductivity, comprises a rather large thermal assistance due to its very low layer thickness thus not contributing significantly to heat transfer between the area regions 102, 104.

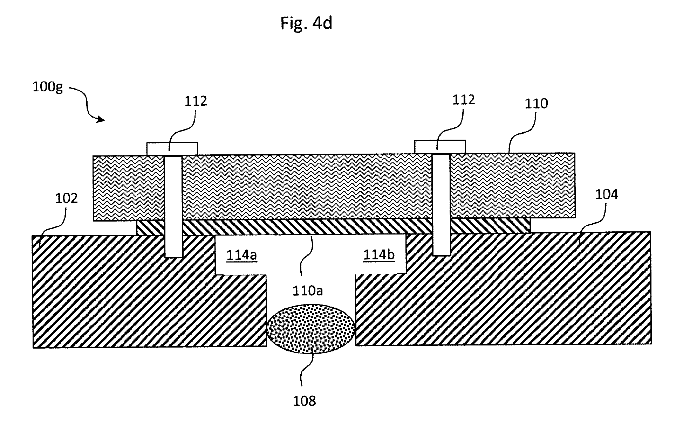

Figure 4d depicts a further embodiment 100g. The circuit carrier 110 is attached to the housing element 100g or its respective area regions 102, 104 by means of screws 112. In contrast to the previous embodiment explained above with reference to figure 4c, the portions 102, 104 of the housing element 100g according to figure 4d comprise recesses 114a, 114b which further increase the thermal resistance between the components 102, 104.

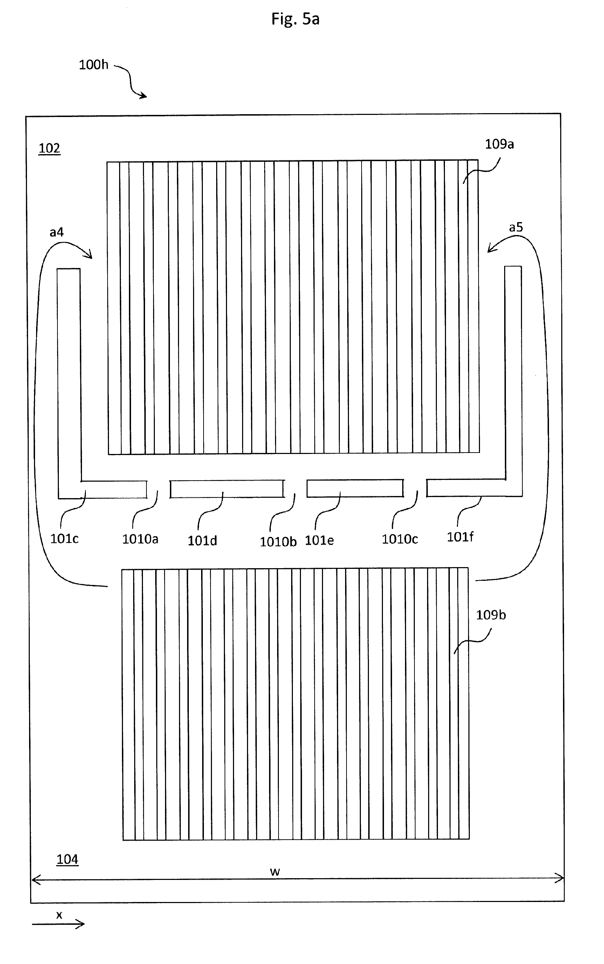

Figure 5a depicts a housing element 100h according to a further embodiment. Specifically, a top view of an outer surface side 100_b (also cf. Fig. 1c) is depicted by figure 5a. The housing element 100h comprises two distinct cooling units 109a, 109b which may e.g. comprise a plurality of cooling fins or the like each. Thereby, an efficient heat transfer to a surrounding environment is enabled. A plurality of openings 101c, 101d, 101e, 101f is also provided within the housing element 100h to attain an increased thermal resistance between the area regions 102, 104 of the housing element 100h. For example, a thermal energy flow from region 104 to region 102 is depicted by arrows a4, a5. As can be seen from figure 5a, the openings 101d, 101e comprise basically slit form and extend with their longitudinal axes basically parallel to a width coordinate x, i.e. in a horizontal direction in figure 5a.

This also holds true for portions of the further openings 101c, 101f which additionally also comprise opening sections that extend perpendicular to the width coordinate x, i.e. in a vertical direction of figure 5a. In other words, the openings 101c, 101f comprise basically L-shape, whereby an aggregated opening configuration is attained by all openings 101c, 101d, 101e, 101f which comprises basically a U-shape.

The openings 101c, 101d, 101e, 101f are separated by comparatively small lands 1010a, 1010b, 1010c which advantageously increase the mechanical stability of the housing element 100h. At the same time, due to their comparatively small dimensions, the lands 1010a, 1010b, 1010c do not substantially contribute to thermal conductivity between regions 102, 104.

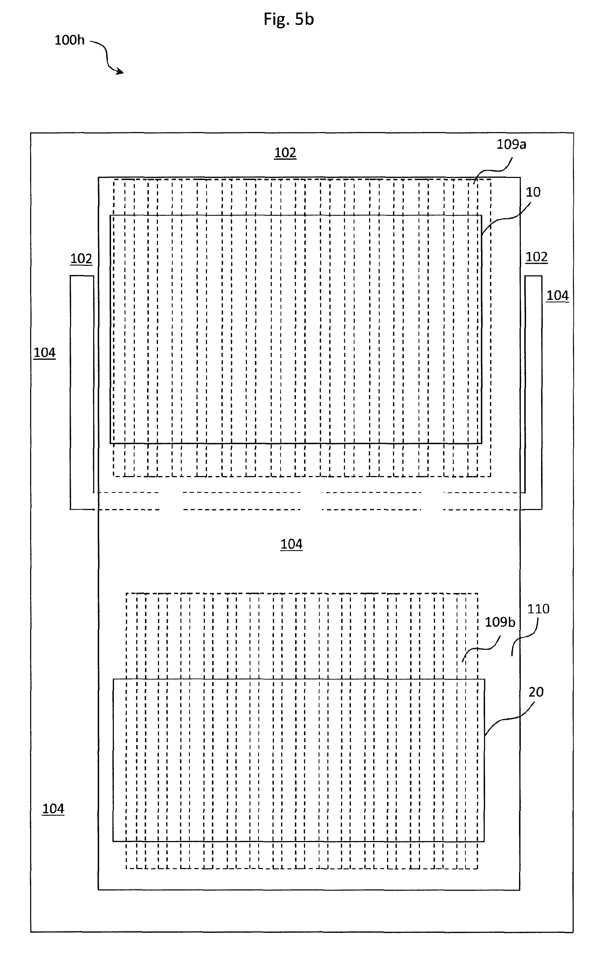

Figure 5b depicts a top view of an inner side surface 100_a (also cf. figure 1b) of the housing element 100h according to figure 5a.

It can be seen that a printed circuit board 110 is provided which may e.g. be attached to the housing element 100h by screws or other fixing means well known to the skilled man. Advantageously, the portion of the printed circuit board 110 which faces the first area region 102 of the housing element 100h (or any components 10 comprised therein) can be cooled by means of the first cooling unit 109a so that a direct heat transfer from an inside of a housing comprising the housing element 100h to an outside of the housing element 100h can be effected without significant heat transfer to the other area region 104 of the housing element 100h. This is inter alia due to the openings 101c, .., 101f explained above with reference to figure 5a.

Likewise, the further electronic components 20, which are comprised within area region 104 of the housing element 100h or on a respective portion of the printed circuit board 110 may directly by cooled by the further cooling unit 109b.

The configuration depicted by figure 5a, 5b advantageously enables to provide an efficient heat transfer from an inside of a housing comprising the housing element 100h to an outside of said housing element 100h without significant heat transfer through the housing element 100g itself between area regions 104, 102. Thus, the electronic devices 10, 20 may be operated in a thermally independent manner, although both of them make use of the same housing element 100h for cooling, i.e. heat transfer to a surrounding environment.

Moreover, due to the sealing material attached to or filled into the openings 101c, .., 101f an efficient sealing of a housing comprising the housing element 100h is enabled, whereby environmental influences may be reduced.

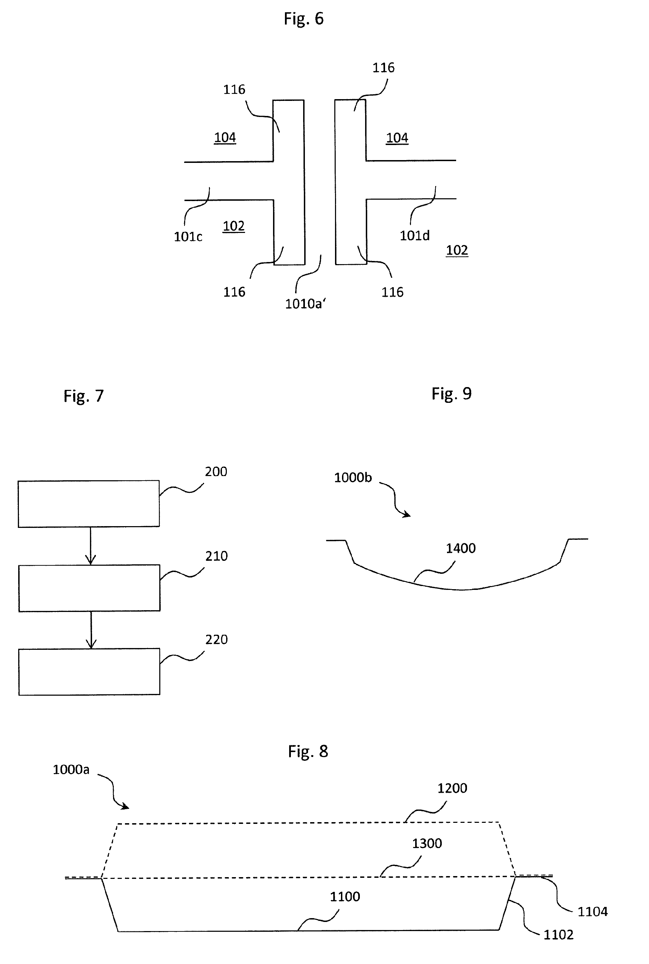

Figure 6 depicts a detail of a land 1010a' which comprises an extended thermal resistance as compared to e.g. the land 1010a as depicted by figure 5a.

As can be seen from figure 6, recesses 116 are provided surrounding the land 1010a' thereby effectively increasing the thermal resistance between the area regions 102, 104 of the housing element surrounding the land 1010a'.

The housing element according to the embodiments may advantageously be used to provide a housing 1000 (figure 1c) for electronic components 10, 20 such as remote radio heads for base stations of cellular communications systems. Such radio heads usually comprise a first electronic device 10 such as power amplifier circuitry or the like which dissipates a comparatively large amount of heat energy. Moreover, the radio heads comprise further electronics such as low power electronics 20, e.g. signal processing units and the like, which dissipate a comparatively small amount of heat energy. The electronic devices 10, 20 of such a remote radio head may advantageously be attached to the different area regions 102, 104 of the housing element 100h (Fig. 5a) which are thermally separated from each other according to the principle of the embodiments. Thus, thermal energy exchange between the components 10, 20 is reduced. At the same time, a single printed circuit board 110 (figure 5a, 5b) may be used to receive the respective electronic components 10, 20. Moreover, a substantial mechanical stability is given by a monolithic housing element 100h (figure 5a) that nevertheless provides different thermal area regions 102, 104 which usually comprise different temperature levels during operation of the remote radio head due to the improved thermal separation of the area regions 102, 104.

Of course, the principle according to the embodiments is not limited to the application of remote radio heads. Other electronic devices comprising elements having different operating temperatures may also be extended by applying the principle according to the embodiments.

Although e.g. Fig. 1a depicts a basically planar configuration of the housing element 100, according to further embodiments, the housing element may also comprise a non-planar shape or generally any other shape suitable and/or required for forming at least a part of a housing for a further device such as electronic components or the like. For example, according to a preferred embodiment, the housing element may also comprise a clamshell-type form.

Fig. 8 schematically depicts a side view of a housing 1000a according to a further embodiment, one component of which is formed by a housing element 1100 according to the embodiments. The housing 1000a in total comprises two "clam shells" 1100, 1200. The first shell 1100 comprises a basically planar base section, which may e.g. be implement as explained above with reference to items 100, 100a, .., 100h. Further, the first shell 1100 comprises side wall sections 1102 and flange sections 1104 which may e.g. comprise fixing means (screws or the like) for connecting to the further housing component 1200, which may be formed like element 1100. However, a combination of a first shell 1100 with a planar further housing element 1300 is also possible. Either component 1100, 1200, 1300 or only one of them, may comprises at least one opening 101 plus sealing material 108 according to the principle of the embodiments. According to a further embodiment, the at least one opening 101 plus sealing material 108 according to the principle of the embodiments may also be comprised in the side wall sections 1102 and/or even in the flange sections 1104.

Figure 9 schematically depicts a side view of a housing 1000b according to a further embodiment, wherein said housing 1000b comprises a curved surface. At least one opening 101 plus sealing material 108 according to the principle of the embodiments may be provided in said curved surface.

Figure 7 schematically depicts a simplified flow chart of a method according to an embodiment. In a first step 200, a housing element 100 (Fig. 1a) comprising thermally conductive material is provided, i.e. by die casting. In subsequent step 210, at least one opening 101 between adjacent area regions 102, 104 of said housing element 100 is provided to increase a thermal resistance between said area regions 102, 104. After that, in step 220, said at least one opening 101 is at least partly filled with sealing material 108.

According to a further embodiment, said at least one opening 101 is provided during a process of die casting 200 said housing element 100 and/or b) after a process of die casting 200 said housing element 100, e.g. by milling. In other words, said steps 200, 210 of Fig. 7 may also be carried out at least partly simultaneously or in an overlapping fashion.

According to a further embodiment, it is also possible to use an extrusion profile for forming the housing element 100 and cooling fins 109a, 109b and to press this into a die cast of a further housing component. Thus, only a few joints around the extrusion profile part are required, and the gap 101 is filled with e.g. silicone as sealing material 108. According to a further embodiment, the pressin process can be controlled so that a first (i.e., low power) section 102 of the housing element 100 and the extrusion profile are co-planar. As extrusion profiles have a better thermal conductivity and allow much thinner fins than die cast, the advantage would be lower weight, more air flow and better surface quality (less turbulences), and possibly less machining on the high power section.

According to further embodiments, nearly arbitrary arrangements of high- and low power sections in the regions 102, 104 (e.g. side by side instead of one above the other, or even at least partly surrounding each other) are also possible.

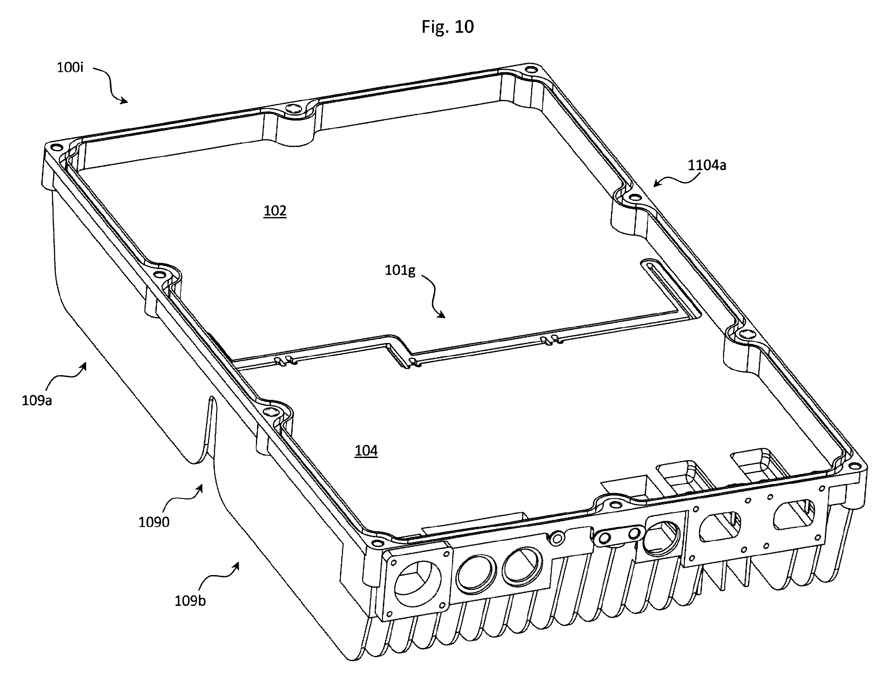

Figure 10 schematically depicts a perspective view of a housing element 100i according to a further embodiment. The housing element 100i comprises a basically planar base plate section for mounting of devices 10, 20 as described above, said base plate section of the housing element 100i comprising an opening 101g between adjacent area regions 102, 104 of the housing element 100i to increase a thermal resistance between said area regions 102, 104. According to the present embodiment, several slit-type and/or basically L-shaped openings are provided, which provide a good thermal separation of the base plate sections 102, 104. Mechanical stability of the base plate is ensured by several stands, i.e. material portions of the base plate connecting the regions 102, 104 with each other, which, however, have a comparatively small cross-section to increase their thermal resistance. The opening 101g is also filled with sealing material (not shown) such as at least one of: polymerized siloxanes, epoxides, stainless steel, aerogel, or any combination thereof to provide protection from environmental influences.

On its outer surface side, the housing element 100i comprises two distinct cooling units 109a, 109b, each of which exemplarily comprises a plurality of cooling fins. As can be seen from Fig. 10, the cooling fins of the two distinct cooling units 109a, 109b are separated by a gap 1090 to ensure further thermal separation of the area regions 102, 104 and the components 109a, 109b. Preferably, the housing element 100i may be obtained as a monolithic (i.e., one piece) element, i.e. obtained by die casting, whereby good thermal conductivity between region 102 and the cooling unit 109a (and in analogy between region 104 and its associated cooling unit 109b) is enabled, which enables efficient cooling of components attached to the respective portions 102, 104 of the housing element. However, due to the opening 100g and also the gap 1090, the thermal resistance between items 109a and 109b (and between items 102, 104) is rather large.

Flange section 1104a comprises mounting means such as e.g. screw holes for establishing a mechanical connection to further housing elements (not shown). According to an embodiment, the housing element 100i of Fig. 10 may be completed to a closed housing by adding a similar or identical housing element 100i and attaching them together with their flange sections 1104a.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

## Claims

1. Housing element (100) for an electronic device (10, 20), wherein said housing element (100) comprises thermally conductive material, wherein said housing element (100) comprises at least one opening (101) between adjacent area regions (102, 104) of said housing element (100) to increase a thermal resistance between said area regions (102, 104), and wherein said at least one opening (101) is at least partly filled with sealing material (108).

2. Housing element (100) according to claim 1, wherein said thermally conductive material of said housing element (100) comprises a thermal conductivity of about 100 W / (m * K) or higher, wherein said thermally conductive material comprises for example one of: magnesium, brass, aluminium, gold, copper, silver.

3. Housing element (100) according to one of the preceding claims, wherein said sealing material comprises a thermal conductivity of about 20 W / (m * K) or less, preferably of about 1 W / (m * K) or less, wherein said sealing material comprises for example at least one of: polymerized siloxanes, epoxides, stainless steel, aerogel.

4. Housing element (100) according to one of the preceding claims, wherein said housing element (100) comprises a basically rectangular shape, and wherein said at least one opening (101a, 101b, 101c) extends substantially parallel to one edge of said rectangular shape, wherein said at least one opening (101a, 101b, 101c) preferably comprises a slit (101).

5. Housing element (100) according to one of the preceding claims, wherein the sealing material (108a) does not cover a whole cross-section area (A) of said at least one opening (101).

6. Housing element (100) according to one of the preceding claims, wherein an aggregated length of said opening (101) or openings (101c, 101d, 101e, 101f) along a width coordinate (x) is greater than 60 percent of a total width (w) of said housing element (100), preferably greater than 85 percent of said total width (w) of said housing element (100).

7. Housing element (100) according to one of the preceding claims, wherein a plurality of openings (101c, 101d, 101e, 101f) are provided, wherein an aggregated shape of said plurality of openings (101c, 101d, 101e, 101f) basically corresponds to a "U"-shape.

8. Housing element (100) according to one of the preceding claims, wherein one or more opposing edge sections of said area regions (102, 104) comprise a recess (114a, 114b; 116).

9. Housing element (100) according to one of the preceding claims, wherein a circuit carrier (110) for receiving at least one of said electronic devices (10, 20) is provided on an inner surface (100_a) of said housing element (100), wherein said circuit carrier (110) preferably at least partly extends over both adjacent area regions (102, 104) of said housing element (100).

10. Housing element (100) according to claim 9, wherein said circuit carrier (110) comprises at least one electrically conductive surface (110a) that is arranged to at least partly cover said at least one opening (101), wherein said at least one electrically conductive surface (110a) preferably establishes an electrically conductive contact between said adjacent area regions (102, 104) of said housing element (100).

11. Housing element (100) according to one of the preceding claims, wherein said housing element (100) comprises at least one cooling unit (109; 109a, 109b) on an outer surface (100_b), wherein preferably at least two distinct cooling units (109a, 109b) are associated with respective ones of said area regions (102, 104).

12. Housing (1000; 1000a; 1000b) for an electronic device (10, 20), wherein said housing (1000) comprises at least one housing element (100, 100a, 100b, 100c, 100d, 100e, 100f, 100g) according to one of the preceding claims.

13. Method of providing a housing element (100) for an electronic device (10, 20), wherein said method comprises: providing (200) said housing element (100) comprising thermally conductive material, providing (210) at least one opening (101), preferably a slit (101), between adjacent area regions (102, 104) of said housing element (100) to increase a thermal resistance between said area regions (102, 104), at least partly filling (220) said at least one opening (101) with sealing material (108).

14. Method according to claim 13, wherein said at least one opening (101) is provided a) during a process of die casting said housing element (100) and/or b) after a process of die casting said housing element (100), e.g. by milling.

## Amended claims

### Amended claims in accordance with Rule 137(2) EPC.

1. Housing element (100) for an electronic device (10, 20), wherein said housing element (100) comprises thermally conductive material, wherein said housing element (100) comprises at least one opening (101) between adjacent area regions (102, 104) of said housing element (100) to increase a thermal resistance between said area regions (102, 104), and wherein said at least one opening (101) is at least partly filled with sealing material (108), wherein a circuit carrier (110) for receiving at least one of said electronic devices (10, 20) is provided on an inner surface (100_a) of said housing element (100), wherein said circuit carrier (110) at least partly extends over both adjacent area regions (102, 104) of said housing element (100).

2. Housing element (100) according to claim 1, wherein said thermally conductive material of said housing element (100) comprises a thermal conductivity of about 100 W / (m * K) or higher, wherein said thermally conductive material comprises for example one of: magnesium, brass, aluminium, gold, copper, silver.

3. Housing element (100) according to one of the preceding claims, wherein said sealing material comprises a thermal conductivity of about 20 W / (m * K) or less, preferably of about 1 W / (m * K) or less, wherein said sealing material comprises for example at least one of: polymerized siloxanes, epoxides, stainless steel, aerogel.

4. Housing element (100) according to one of the preceding claims, wherein said housing element (100) comprises a basically rectangular shape, and wherein said at least one opening (101a, 101b, 101c) extends substantially parallel to one edge of said rectangular shape, wherein said at least one opening (101a, 101b, 101c) preferably comprises a slit (101).

5. Housing element (100) according to one of the preceding claims, wherein the sealing material (108a) does not cover a whole cross-section area (A) of said at least one opening (101).

6. Housing element (100) according to one of the preceding claims, wherein an aggregated length of said opening (101) or openings (101c, 101d, 101e, 101f) along a width coordinate (x) is greater than 60 percent of a total width (w) of said housing element (100), preferably greater than 85 percent of said total width (w) of said housing element (100).

7. Housing element (100) according to one of the preceding claims, wherein a plurality of openings (101c, 101d, 101e, 101f) are provided, wherein an aggregated shape of said plurality of openings (101c, 101d, 101e, 101f) basically corresponds to a "U"-shape.

8. Housing element (100) according to one of the preceding claims, wherein one or more opposing edge sections of said area regions (102, 104) comprise a recess (114a, 114b; 116).

9. Housing element (100) according to one of the preceding claims, wherein said circuit carrier (110) comprises at least one electrically conductive surface (110a) that is arranged to at least partly cover said at least one opening (101), wherein said at least one electrically conductive surface (110a) preferably establishes an electrically conductive contact between said adjacent area regions (102, 104) of said housing element (100).

10. Housing element (100) according to one of the preceding claims, wherein said housing element (100) comprises at least one cooling unit (109; 109a, 109b) on an outer surface (100_b), wherein preferably at least two distinct cooling units (109a, 109b) are associated with respective ones of said area regions (102, 104).

11. Housing (1000; 1000a; 1000b) for an electronic device (10, 20), wherein said housing (1000) comprises at least one housing element (100, 100a, 100b, 100c, 100d, 100e, 100f, 100g) according to one of the preceding claims.

12. Method of providing a housing element (100) for an electronic device (10, 20), wherein said method comprises: providing (200) said housing element (100) comprising thermally conductive material, providing (210) at least one opening (101), preferably a slit (101), between adjacent area regions (102, 104) of said housing element (100) to increase a thermal resistance between said area regions (102, 104), at least partly filling (220) said at least one opening (101) with sealing material (108), wherein said method further comprises providing a circuit carrier (110) for receiving at least one of said electronic devices (10, 20) on an inner surface (100_a) of said housing element (100), wherein said circuit carrier (110) at least partly extends over both adjacent area regions (102, 104) of said housing element (100).

13. Method according to claim 12, wherein said at least one opening (101) is provided a) during a process of die casting said housing element (100) and/or b) after a process of die casting said housing element (100), e.g. by milling.
